**Europäisches Patentamt**

**European Patent Office**

**Office européen des brevets**

(11) Veröffentlichungsnummer: **0 229 282**
**B1**

(12) **EUROPÄISCHE PATENTSCHRIFT**

(45) Veröffentlichungstag der Patentschrift:
**27.09.89**

(21) Anmeldenummer: **86116638.7**

(22) Anmeldetag: **29.11.86**

(51) Int. Cl.⁴: **C 23 C 16/30**

(54) Verfahren zur Herstellung eines beschichteten Formkörpers.

(30) Priorität: **19.12.85 DE 3544975**

(43) Veröffentlichungstag der Anmeldung:
**22.07.87 Patentblatt 87/30**

(45) Bekanntmachung des Hinweises auf die Patenterteilung:
**27.09.89 Patentblatt 89/39**

(84) Benannte Vertragsstaaten:
**AT DE FR GB**

(56) Entgegenhaltungen:
**CH-A- 452 205**
**CH-A- 507 094**
**FR-A- 2 130 445**

(73) Patentinhaber: **Fried. Krupp Gesellschaft mit
beschränkter Haftung, Altendorfer Strasse 103,
D-4300 Essen 1 (DE)**

(72) Erfinder: **Van den Berg, Henk, Dr. rer. nat.,
Hans-Niemeyer-Strasse 8, D-4300 Essen (DE)**
Erfinder: **König, Udo, Dr. rer. nat., Helgolandring 31,
D-4300 Essen 1 (DE)**
Erfinder: **Reiter, Norbert, Dr.-Ing., Hunsrückstrasse 29,
D-4020 Mettmann (DE)**

(74) Vertreter: **Vomberg, Friedhelm, Dipl.-Phys.,
Graf-Recke-Strasse 231, D-4000 Düsseldorf 1 (DE)**

## Beschreibung

Die Erfindung betrifft ein Verfahren zur Herstellung eines beschichteten Formkörpers, bei dem auf einem metallischen Grundkörper mindestens eine aus den Carbiden, Nitriden und/oder Carbonitriden der Elemente Titan, Zirkonium, Hafnium, Vanadium, Niob und/oder Tantal bestehende Hartstoffschicht nach dem CVD-Prozeß aus einer reaktiven Gasphase abgeschieden wird. Derartige Formkörper haben eine gute Verschleißfestigkeit und werden deshalb insbesondere als Werkzeuge zur spanenden und spanlosen Formgebung von metallischen Werkstücken verwendet.

Aus der CH-PS 507 094 ist ein Formkörper bekannt, der aus einer Harmetallunterlage und mindestens einer Hartstoffschicht besteht, wobei die Hartmetallunterlage aus einem oder mehreren Hartstoffen und mindestens einem Bindemittel zusammengesetzt ist und wobei die Hartstoffschicht harte Carbide oder Nitride enthält. Derartige Formkörper können für Werkzeuge der spanabhebenden und spanlosen Formgebung verwendet werden, da sie gute Verschleißeigenschaften besitzen. Die bekannten Formkörper nach dem CVD-Prozeß (Chemical Vapor Deposition-Prozeß) hergestellt, wie er beispielsweise in der CH-PS 452 205 beschrieben ist. Beim CVD-Prozeß, der heute zu den gebräuchlichen Beschichtungsmethoden gehört, wird aus einer reaktiven Gasatmosphäre, die in der Regel eine Temperatur von 600 bis 1200°C hat, auf einem Substrat eine Oberflächenschicht abgeschieden. Die Gasatmosphäre enthält mehrere Verbindungen, die bei der Reaktionstemperatur miteinander reagieren und den in der Oberflächenschicht vorhandenen Stoff bilden. Es ist z.B. allgemein üblich, metallische Substrate mit Hartstoffschichten aus Carbiden, Nitriden oder Carbonitriden zu überziehen, wobei die Gasatmosphäre Halogenide der Elemente der III. bis VI. Gruppe des Periodensystems und eine stickstoffhaltige Verbindung bzw. eine kohlenstoffhaltige Verbindung enthält. So wird auf einem Hartmetallgrundkörper eine Titancarbidschicht bei ca. 1000°C aus einer Gasatmosphäre abgeschieden, die Titantetrachlorid und Methan enthält. Als kohlenstoffhaltige Verbindungen werden insbesondere gasförmige Kohlenwasserstoffe verwendet, während als stickstoffhaltige Verbindungen $N_2$, $NH_3$ oder Amine zur Anwendung kommen.

Es hat sich gezeigt, daß die Abscheidung von harten Carbiden, Nitriden und Carbonitriden auf metallischen Grundkörpern nach dem CVD-Prozeß eine recht lange Reaktionszeit benötigt, da die Abscheidegeschwindigkeit bei ca. 1 bis 2 µm/h liegt, und daß die Hartstoffschichten eine zu grobe Kornstruktur aufweisen, die ihre Haftbefestigung und Verschleißbeständigkeit vermindert. Da die Hartstoffschichten in der Regel eine Dicke von 8 bis 12 µm aufweisen sollen, ist es erforderlich, daß die Hartstoffschichten eine feinkörnige Struktur haben.

Der Erfindung liegt daher die Aufgabe zugrunde, ein Verfahren zur Herstellung eines beschichteten Formkörpers zu schaffen, das einerseits eine gegenüber dem bekannten CVD-Verfahren verkürzte Beschichtungszeit benötigt und das andererseits sehr feinkörnige Hartstoffschichten liefert.

Die der Erfindung zugrundeliegende Aufgabe wird dadurch gelöst, daß die Gasatmosphäre Aluminiumtrichlorid, Aluminiumtribromid oder Magnesiumchlorid im Molverhältnis 0,1 : 1 bis 5 : 1, bezogen auf die Halogenide des Titans, Zirkoniums, Hafniums, Niobs und/oder Tantals, enthält. Es hat sich nämlich überraschenderweise gezeigt, daß diese Verbindungen die Geschwindigkeit der Beschichtung erheblich erhöhen. Außerdem haben die in Anwesenheit dieser Verbindungen gebildeten Schichten eine sehr feine Struktur. Die nach dem erfindungsgemäßen Verfahren hergestellten Hartstoffschichten haben eine große Haftfestigkeit und Verschleißbeständigkeit, was insbesondere auf die Feinkörnigkeit der Schichten zurückgeführt wird.

Nach der Erfindung ist ferner vorgesehen, daß der metallische Grundkörper aus Hartmetall besteht, denn auf diese Weise können besonders verschleißfeste Formkörper hergestellt werden, die sich insbesondere zur zerspanenden Bearbeitung metallischer Werkstücke eignen.

In weiterer Ausgestaltung der Erfindung ist vorgesehen, daß der CVD-Prozeß bei 800 bis 1100°C durchgeführt wird. In diesem Temperaturbereich wird der Abscheidungsprozeß in günstiger Weise beeinflußt, denn auch bei den niedrigen Temperaturen stellt sich eine hinreichend hohe Abscheidegeschwindigkeit ein und bei den hohen Temperaturen bildet sich ein feinkörniges Gefüge.

Der Gegenstand der Erfindung wird nachfolgend anhand der Abbildungen und eines Ausführungsbeispiels näher erläutert.

Es zeigen:

Fig. 1 Fotografie des Bruchgefüges eines nach dem erfindungsgemäßen Verfahren hergestellten beschichteten Formkörpers,

Fig. 2 Ergebnis der Schneidhaltigkeitsuntersuchung von Wendeschneidplatten, die nach dem erfindungsgemäßen Verfahren beschichtet wurden.

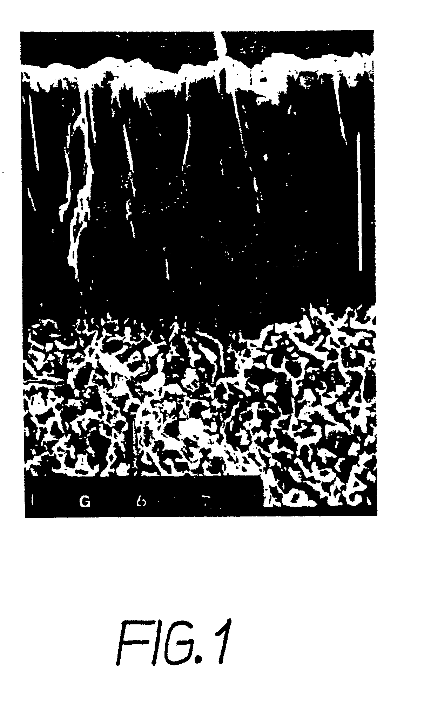

In einem elektrisch beheizten Reaktionsgefäßt aus hitzebeständigem Stahl wurden Wendeschneidplatten aus Hartmetall mit der Zusammensetzung 82,5% W, 11% (Ti, Ta, Nb) C und 6,5% Co (Massenprozente) gelagert. Diese Wendeschneidplatten wurden innerhalb eines Zeitraums von 90 Minuten in einer Inertgasatmosphäre auf eine Temperatur von 1005°C erwärmt. Nach dem Erreichen der Temperatur wurde der Druck von anfangs 100 000 Pascal auf 50 000 Pascal gesenkt und ein aus 0,9% $TiCl_4$, 1,5% $AlCl_3$, 27% $N_2$ und 70,6% $H_2$ (Atom-%) bestehendes Gasgemisch über die Wendeschneidplatten geleitet. Nach Ablauf von 165 Minuten wurde der Abscheidungsprozeß beendet, und die beschichteten Wendeschneidplatten wurden in einer Wasserstoffatmosphäre auf Raumtemperatur abgekühlt. Die auf den Wendeschneidplatten abgeschiedene Hartstoffschicht hatte eine Dicke bis zu 17 µm, was außerordentlich überraschend war, da durch Erfahrung bekannt ist, daß unter gleichartigen Bedingungen, jedoch ohne Zugabe von $AlCl_3$, nur Schichtdicken von etwa 6 bis 8 µm erwartet werden können. Die Beschichtung hatte eine goldglänzende Farbe, was auf eine hohe Oberflächengüte zurückzuführen ist. Eine der beschichteten Wendeschneidplatten wurde zerbrochen, und danach wurde das Gefüge des Bruchs mit einem Rasterelektrodenmikroskop untersucht. Die fotographische Abbildung dieses Bruchgefüges (Fig. 1) zeigt, daß die Hartstoffschicht aus sehr dicht gewachsenem feinkörnigem Material besteht.

Eine Röntgenbeugungsuntersuchung zeigte, daß das Material der Hartstoffschicht aus polykristallinem Titannitrid mit einer Gitterkonstanten von a = 0,4242 nm besteht. Andere Phasen konnten nicht identifiziert werden. Die Mikrohärte HV 0,05 der Hartstoffschicht lag im Bereich von 2200 bis 2600. Auch die Prüfung der Haftfestigkeit der Hartstoffschicht ergab überdurchschnittlich hohe Werte. Durch Analysen mit einer Elektronenstrahlmikrosonde und mit einem Röntgenfluoreszenzgerät konnte innerhalb der Nachweisgrenze der Geräte (kleiner als 0,05 Massen-% Al) kein Aluminium nachgewiesen werden. Auch dieses Ergebnis ist angesichts der zugeführten $AlCl_3$-Mengen überraschend. Alle Ergebnisse zeigen, daß das Aluminiumchlorid einen positiven katalytischen Einfluß auf die Abscheidung von Titannitrid hat. Bei der Abscheidung wird kein Aluminium in die Titannitridschicht eingelagert. Das Aluminiumchlorid wird nach dem Verlassen des Reaktors in einer basischen Waschlösung als Aluminiumoxid ausgefällt.

Das erfindungsgemäße Verfahren wurde mehrfach wiederholt, wobei auch Änderungen der Konzentration des Aluminiumchlorids, der Abscheidetemperatur und der Beschichtungszeit vorgenommen wurden. In allen Fällen konnte eine Beschleunigung der Abscheidungsgeschwindigkeit beobachtet werden.

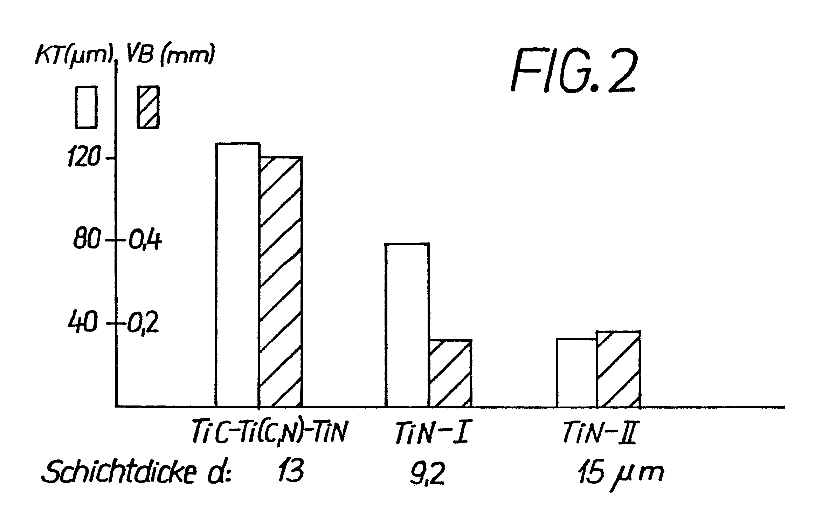

Die nach dem erfindungsgemäßen Verfahren beschichteten Wendeschneidplatten wurden vergleichenden Schneidhaltigkeitsuntersuchungen durch Drehen von Stahl C60N im glatten Schnitt unterworfen. Als Vergleichsmaßstab wurde eine handelsübliche Wendeschneidplatte SNUN 120408 verwendet, die mit einer insgesamt 13 µm dicken Mehrfachbeschichtung aus Titancarbid, Titancarbonitrid und Titannitrid überzogen war. Die Beschichtungszeit der Vergleichs-Wendeschneidplatte betrug 300 Minuten. Derartig beschichteten Wendeschneidplatten werden in der Maschinenbauindustrie in großem Umfang für die Zerspanung von Eisenwerkstoffen bei mittleren bis hohen Schnittgeschwindigkeiten und großen Spanungsquerschnitten verwendet. Das Ergebnis dieser Schneidhaltigkeitsuntersuchungen ist in Fig. 2 dargestellt. Zur Beurteilung der Verschleißbeständigkeit wurde nach den Drehbearbeitungen der Kolkverschleiß KT und der Freiflächenverschleiß VB bestimmt. Die Drehbearbeitungen von Stahl C60N erfolgten unter folgenden Bedingungen:

Drehzeit $t_c$ = 10 Minuten,
Schnittgeschwindigkeit $v_c$ = 220 m/min,
Spanungsquerschnitt $a_p x f$ = 1,5 × 0,28 mm²/ Umdrehung.

Die nach dem erfindungsgemäßen Verfahren beschichtete Wendeschneidplatte TiN-I zeigt trotz geringerer Schichtdicke von 9,2 µm einen erheblich niedrigeren Kolk- und Freiflächenverschleiß als die zum Stand der Technik gehörende, mit einer 13 µm dicken TiC-Ti(C, N)-TiN-Beschichtung überzogene Wendeschneidplatte. Die guten Verschleißkennwerte der nach dem erfindungsgemäßen Verfahren beschichteten Wendeschneidplatte TiN-I werden noch übertroffen von der nach dem erfindungsgemäßen Verfahren hergestellten Wendeschneidplatte TiN-II, deren Hartstoffschicht eine Dicke von 15 µm hat.

In weiteren Untersuchungen wurde gefunden, daß der katalytische Effekt des $AlCl_3$-Zusatzes auch bei der Abscheidung von Titancarbid- und Titancarbonitridschichten sowie von Zirkonnitridschichten vorhanden ist. In bezug auf die Wachstumsgeschwindigkeit wurden die größten Effekte bei der Abscheidung von Nitriden und von stickstoffreichen Carbonitriden festgestellt. Auch die Verwendung von Aluminiumtribromid und Magnesiumchlorid bewirkte eine Erhöhung der Wachstumsgeschwindigkeit bei der Abscheidung von Carbid-, Carbonitrid- und Nitridschichten.

## Patentansprüche

1. Verfahren zur Herstellung eines beschichteten Formkörpers, bei dem auf einem metallischen Grundkörper mindestens eine aus den Carbiden, Nitriden und/oder Carbonitriden der Elemente Titan, Zirkonium, Hafnium, Vanadin, Niob und oder Tantal bestehende Hartstoffschicht nach dem CVD-Prozeß aus einer reaktiven Gasphase abgeschieden wird, die mindestens ein Halogenid der Elemente Titan, Zirkonium, Hafnium, Niob und/oder Tantal, eine stickstoffhaltige Verbindung und/oder eine kohlenstoffhaltige Verbindung enthält und die frei von Sauerstoff sowie sauerstoffhaltigen Verbindungen ist, dadurch gekennzeichnet, daß eine Gasphase, die Aluminiumtrichlorid, Aluminiumtribromid oder Magnesiumchlorid im Molverhältnis 0,1 : 1 bis 5 : 1, bezogen auf die Halogenide des Titans, Zirkoniums, Hafniums, Niobs und/oder Tantals, enthält, eingesetzt wird.

2. Verfahren nach Anspruch 1, dadurch gekennzeichnet, daß ein metallischer Grundkörper aus Hartmetall beschichtet wird.

3. Verfahren nach den Ansprüchen 1 bis 2, dadurch gekennzeichnet, daß der CVD-Prozeß bei 800 bis 1100°C durchgeführt wird.

## Claims

1. A process for the preparation of a coated moulding, wherein at least one layer of a mechanically resistant material consisting of the carbides, nitrides and/or carbonitrides of titanium, zirconium, hafnium, vanadium, niobium and/or tantalum is separated by the CVD (chemical vapour deposition) process on a metallic base member from a reactive gaseous phase which contains at least one halide of titanium, zirconium, hafnium, niobium and/or tantalum, a nitrogen-containing compound and/or a carbon-containing compound and is free from oxygen and oxygen-containing compounds, characterized in that a gaseous phase is used which contains aluminium trichloride, aluminium tribromide or magnesium chloride in a molar ratio of 0.1 : 1 to 5 : 1, referred to the halides of titanium, zirconium, hafnium, niobium and/or tantalum.

2. A process according to claim 1, characterized in that a metallic base member of a mechanically resistant material is coated.

3. A process according to claims 1 to 2, characterized in that the CVD process is performed at 800 to 1100°C.

**Revendications**

1. Procédé de réalisation d'un corps de formage, revêtu d'une couche, pour lequel, sur un corps métallique de base, a été déposée au moins une couche constituée des carbures, des nitrures et/ou des carbonitrures des éléments titane, zirconium, hafnium, vanadium, niobium et/ou tantale, suivant le procédé CVD, à partir d'une phase gazeuse réactive, qui contient, au moins, un halogénure des éléments titane, zirconium, hafnium, vanadium, niobium et/ou tantale, un composé nitré et/ou un composé carboné, et qui ne contient pas d'oxygène, ni de composés oxygénés, caractérisé en ce que l'on met en œuvre une atmosphère gazeuse contenant du trichlorure d'aluminium, du tribromure d'aluminium ou du chlorure de magnésium dans un rapport molaire compris entre 0,1 : 1 et 5 : 1 par rapport aux halogénures de titane, de zirconium, de hafnium de nobium et/ou de tantale.

2. Procédé suivant la revendication 1, caractérisé en ce qu'un corps de base métallique est recouvert d'une couche de métal dur.

3. Procédé suivant les revendications 1 et 2, caractérisé en ce que le procédé CVD est mis en œuvre de 800 à 1100°C.

FIG.1

FIG.2

KT(μm), VB (mm)

Schichtdicke d:

| TiC-Ti(C,N)-TiN | TiN-I | TiN-II |
| 13 | 9,2 | 15 μm |